# EUROPÄISCHE PATENTSCHRIFT

(11) **EP 3 749 073 B1**
(45) Veröffentlichungstag und Bekanntmachung des Hinweises auf die Patenterteilung: **12.04.2023**
(21) Anmeldenummer: 20173829.1
(22) Anmeldetag: 11.05.2020
(51) Int. Cl.: H05K 7/14, H05K 7/20, H05K 5/00

(54) **ELEKTRISCHES GERÄT**
ELECTRIC DEVICE
APPAREIL ÉLECTRIQUE

(30) Priorität: 05.06.2019 DE 102019208213
(43) Veröffentlichungstag der Anmeldung: 09.12.2020
(73) Patentinhaber: Siemens Aktiengesellschaft, 80333 München (DE)
(72) Erfinder: Lude, Eric, 15745 Wildau (DE); Roop, Felix, 13125 Berlin (DE)
(74) Vertreter: Siemens Patent Attorneys

(56) Entgegenhaltungen:
- EP-A1- 3 057 387
- DE-A1- 2 747 712
- DE-A1- 4 413 453
- DE-T2- 69 322 368

## Beschreibung

Die Erfindung betrifft ein elektrisches Gerät mit einem an der Frontseite offenen Gehäuse, einer Frontplatte, die auf der Frontseite des Gehäuses aufgesetzt ist, und Leiterplatten, die von dem Gehäuse umfasst sind, wobei die Leiterplatten in Haltevorrichtungen eingeschoben sind, die an der dem Gehäuse zugewandten Seite der Frontplatte angeordnet sind, und zumindest zwei der Leiterplatten nicht parallel zueinander ausgerichtet sind.

Ein solches Gerät ist beispielsweise aus der DE 693 22 368 T2 oder der DE 44 13 453 A1 bekannt. Ein weiteres elektrisches Gerät ist aus der DE 197 17 909 C1 bekannt. Bei diesem bekannten Gerät handelt es sich um ein elektrisches Schutzgerät der Siemens AG. Das bekannte elektrische Gerät umfasst ein Gehäuse, auf das eine Frontplatte aufgesetzt werden kann. Die Frontplatte umfasst ein Display sowie eine Folientastatur. Innerhalb des elektrischen Gerätes sind Leiterplatten vorgesehen, die mittels eines Flachbandkabels als Systembus untereinander verbunden sind.

Zur Herstellung des bekannten Geräte sind mehrere manuelle Fertigungsschritte erforderlich. Hierbei müssen häufig Werkzeuge gewechselt sowie die Fügerichtung, also die Ausrichtung eines Werkzeugs in Bezug auf das elektrische Gerät, verändert werden. Teile des Herstellungsprozesses können bei dem bekannten Gerät zwar automatisiert ablaufen, eine vollständig automatisierte Fertigung, beispielsweise mittels eines Fertigungsroboters, ist jedoch nicht möglich.

Der Erfindung liegt daher die Aufgabe zugrunde, ein elektrisches Gerät anzugeben, das bei möglichst stabiler Konstruktion automatisch gefertigt werden kann.

Zur Lösung dieser Aufgabe wird ein gattungsgemäßes elektrisches Gerät angegeben, bei dem eine Stirnseite mindestens einer der zumindest zwei Leiterplatten in einer Führungsnut eines Kühlkörpers gehalten ist, der auf der anderen der zumindest zwei Leiterplatten montiert ist.

Das erfindungsgemäße elektrische Gerät kann automatisch gefertigt werden, da die Frontplatte quasi als Basisplatte für den Fügeprozess verwendet wird. Die Leiterplatte werden in derselben Fügerichtung auf die dem Gehäuse zugewandte Seite der Frontplatte aufgesetzt wie abschließend das Gehäuse, über die mit den Leiterplatten fertig bestückte Frontplatte gestülpt wird. Auf diese Weise kann eine einfache Roboterfertigung realisiert werden. Da die Leiterplatten in die Haltevorrichtung auf der Frontplatte eingeschoben werden, kann zudem auf eine robotisch aufwendiger zu realisierende Verschraubung von Komponenten verzichtet werden.

Außerdem kann die Stabilität der Leiterplatten während der Fertigung und des Betriebs erhöht werden, da sie aufgrund der nicht parallelen Ausrichtung zueinander verschränkte Kippachsen aufweisen. Außerdem kann vorgesehen sein, dass sich die nicht parallel ausgerichteten Leiterplatten gegenseitig berühren und damit gleichsam aneinander abstützen.

Erfindungsgemäß kann ohne zusätzliche Bauteile, die den Fertigungsprozess des elektrischen Gerätes erschweren würden, eine möglichst stabile Konstruktion geschaffen werden. Dadurch dass eine Leiterplatte in einer Führungsnut eines Kühlkörpers auf der anderen Leiterplatte gehalten ist, kann nämlich mit einfachen Mitteln eine hohe Stabilität gegen ein Verwackeln der Leiterplatten erreicht werden. Zudem kann der Fertigungsprozess unterstützt werden, da durch die Führungsnut eine Fügerichtung vorgegeben und genaue Positionierung der Leiterplatten unterstützt werden kann. Bei dieser Ausführungsform findet quasi eine Funktionsintegration hinsichtlich des Kühlkörpers statt. Einerseits dient er gemäß seiner ursprünglichen Funktion zur Abfuhr von Verlustleistung eines wärmeabgebenden Bauteils, z.B. einer CPU, derjenigen Leiterplatte, auf der er aufgebracht ist. Außerdem dient er auch zur Führung der anderen Leiterplatten während des Fertigungsprozesses sowie letztlich zur mechanischen Stabilisierung der gesamten Leiterplattenanordnung.

Konkret kann vorgesehen sein, dass die zumindest zwei Leiterplatten orthogonal zueinander ausgerichtet sind.

Gemäß einer vorteilhaften Ausführungsform des erfindungsgemä-ßen elektrischen Gerätes kann vorgesehen sein, dass das Volumen des Kühlkörpers derart bemessen ist, dass er die von einem wärmeabgebenden Bauteil abgegebene Wärmemenge vollständig aufnehmen kann, wobei eine maximale Grenztemperatur nicht überschritten wird.

Diese Ausführungsform sieht vor, dass der Kühlkörper derart ausgelegt ist, dass er allein durch sein entsprechend groß ausgelegtes Volumen die benötigte Wärmeabfuhr ermöglichen kann. Er kann daher vergleichsweise einfach konstruiert sein, beispielsweise in Form eines Quaders mit ausreichend bemessenem Volumen. Auf das Aufbringen spezieller Oberflächenstrukturen und/oder Kühlrippen kann somit zugunsten einer einfachen Konstruktion verzichtet werden. Außerdem kann auf diese Weise der Kühlkörper in einer Weise ausgeformt werden, die hinsichtlich seiner Funktion als Halterung für die Leiterplatten optimiert ist, insbesondere können Führungsnuten ohne Rücksichtnahme auf etwaige Oberflächenanforderungen des Kühlkörpers an den zur Halterung der Leiterplatten erforderlichen Stellen des Kühlkörpers vorgesehen werden.

Eine weitere vorteilhafte Ausführungsform des erfindungsgemä-ßen elektrischen Gerätes sieht vor, dass der Kühlkörper derart bemessen ist, dass seine Oberfläche im eingeschobenen Zustand der Leiterplatte zumindest teilweise an der Innenfläche des Gehäuses anliegt.

Hierdurch kann ein besonders guter Wärmeübergang vom Kühlkörper auf das Gehäuse des Geräts erreicht werden. Bei entsprechender Bemessung des Kühlkörpers kann ein gewünschter Anpressdruck bei der Berührung zwischen dem Kühlkörper und der Innenseite des Gehäuses hergestellt werden. Beispielsweise kann der Kühlkörper etwas breiter als das Innenmaß des Gehäuses ausgeführt sein, so dass eine Presspassung zwischen Kühlkörper und Gehäuse hergestellt werden kann. Allerdings muss dabei darauf geachtet werden, dass der Fertigungsprozess nicht behindert wird oder ein Risiko von Beschädigung der Leiterplatte beim Aufschieben des Gehäuses besteht. Beispielsweise kann der Kühlkörper hierfür abgeschrägte Kanten aufweisen, die eine selbsttätige Führung des Gehäuses bei der Fertigung bewirken.

Außerdem kann vorgesehen sein, dass der Kühlkörper im eingeschobenen Zustand der Leiterplatte durch Befestigungsmittel mit dem Gehäuse verbunden ist.

Als Befestigungsmittel kommen beispielsweise Schrauben, Nuten oder Bolzen in Frage, die von der Außenseite des Gehäuses in den Kühlkörper eingeführt werden und einen wärmeleitenden Kontakt zwischen dessen Oberfläche und dem Gehäuse herstellen. Dabei kann anstelle der oben beschriebenen Alternative, bei der der Kühlkörper etwas breiter bemessen ist, auch eine Variante gewählt werden, bei der der Kühlkörper bezüglich der Gehäuseinnenbreite ein leichtes Untermaß aufweist und durch die Befestigungsmittel, z.B. eine Schraubverbindung, das Gehäuse an den Kühlkörper angepresst wird. Diese Variante weist Vorteile bei der Fertigung auf, da die Leiterplatte mit dem Kühlkörper nicht gegen einen mechanischen Widerstand in das Gehäuse eingeschoben werden muss.

Gemäß einer weiteren vorteilhaften Ausführungsform des erfindungsgemäßen elektrischen Gerätes kann vorgesehen sein, dass der Kühlkörper mindestens zwei parallel verlaufende Führungsnuten aufweist. Außerdem kann vorsehen sein, dass in jeder Führungsnut des Kühlkörpers eine Leiterplatte gehalten ist.

Hierdurch kann eine flexible Anordnung geschaffen werden, die zur Halterung entsprechend vieler Leiterplatten durch den Kühlkörper geeignet ist.

Außerdem kann gemäß einer weiteren vorteilhaften Ausführungsform des erfindungsgemäßen elektrischen Gerätes vorgesehen sein, dass der Kühlkörper mindestens eine Halteeinrichtung aufweist, in die ein Halteelement einer von einer Führungsnut gehaltenen Leiterplatte eingreift.

Hierdurch kann eine weitere Stabilisierung der Leiterplattenanordnung erreicht werden, da durch das Zusammenwirken des Haltelementes und der Halteeinrichtung die Leiterplatte in der Führungsnut fixiert wird. Vorteilhaft weist jede der einzuschiebenden Leiterplatten ein Halteelement auf, das in die Halteeinrichtung am Kühlkörper eingreift.

Konkret kann in diesem Zusammenhang vorgesehen sein, dass die Halteeinrichtung als Bohrung ausgebildet ist, die derart im Bereich einer Führungsnut angeordnet ist, dass eine Leiterplatte beim Einschieben in die Führungsnut mit dem Halteelement in die Bohrung eingreift.

Das Halteelement kann bei dieser Ausführungsform beispielsweise als Stift ausgebildet sein, der bei der Fertigung in die Bohrung eingeschoben wird. Die Halteeinrichtung weist hierbei eine der Anzahl der einzuschiebenden Leiterplatten entsprechende Anzahl von Bohrungen auf.

Gemäß einer weiteren vorteilhaften Ausführungsform des erfindungsgemäßen elektrischen Geräts ist vorgesehen, dass die Frontplatte einen Rahmen mit einem das Gehäuse frontseitig umgreifenden Überstand aufweist.

Der Überstand dient dazu, die Frontplatte dicht auf das Gehäuse aufzusetzen.

Außerdem kann vorgesehen sein, dass auf der Frontseite der Frontplatte Eingabemittel und/oder ein Display angeordnet sind. Konkret kann in diesem Zusammenhang vorgesehen sein, dass zum elektrischen Anschluss der Eingabemittel und/oder des Displays mindestens eine der Leiterplatten über einen Steckverbinder mit einer auf der Frontplatte gehäuseseitig angeordneten Platine in Verbindung steht.

Eine weitere vorteilhafte Ausführungsform des erfindungsgemä-ßen elektrischen Gerätes sieht vor, dass mindestens eine der Leiterplatten auf ihrer der Gehäuserückseite zugewandten Stirnseite einen elektrischen Steckverbinder aufweist, der mit einem externen Geräteanschluss, über den von außen mit dem Gerät elektrische Anschlüsse hergestellt werden können, zusammenwirkt.

Der externe Geräteanschluss kann dabei beispielsweise in die Rückwand des Gehäuses integriert sein und gleichsam eine elektrische Verbindung zwischen den äußeren Anschlüssen und den Steckverbindern auf den Leiterplatten bilden.

Schließlich ist gemäß einer weiteren vorteilhaften Ausführungsform des erfindungsgemäßen elektrischen Gerätes vorgesehen, dass die Haltevorrichtungen an der Frontplatte federnde Elemente umfassen, die zum beidseitigen Festklemmen der jeweiligen eingeschobenen Leiterplatte ausgebildet sind.

Auf diese Weise kann eine einfache mechanische Verbindung zum Halten der Leiterplatte an der Frontplatte geschaffen werden, die ohne Schraubverbindungen oder ähnliches auskommt.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: ein Ausführungsbeispiel eines elektrischen Gerätes im zusammengebauten Zustand;
- Figur 2: eine Ansicht des elektrischen Gerätes ohne Gehäuse;
- Figur 3: eine Frontplatte des elektrischen Gerätes, in die zur Fertigung Leiterplatten eingeschoben werden;
- Figuren 4 und 5: verschiedene Ansichten der Frontplatte des elektrischen Gerätes, in die eine weitere Leiterplatte eingeschoben wird;
- Figuren 6 und 7: Schnittdarstellungen des elektrischen Geräts während der Fertigung zur Erläuterung der Anordnung der Leiterplatten;
- Figur 8: eine Schnittdarstellung des elektrischen Gerätes ohne Gehäuse von der Rückseite; und
- Figur 9: eine Schnittdarstellung des elektrischen Gerätes ohne Gehäuse von der Seite.

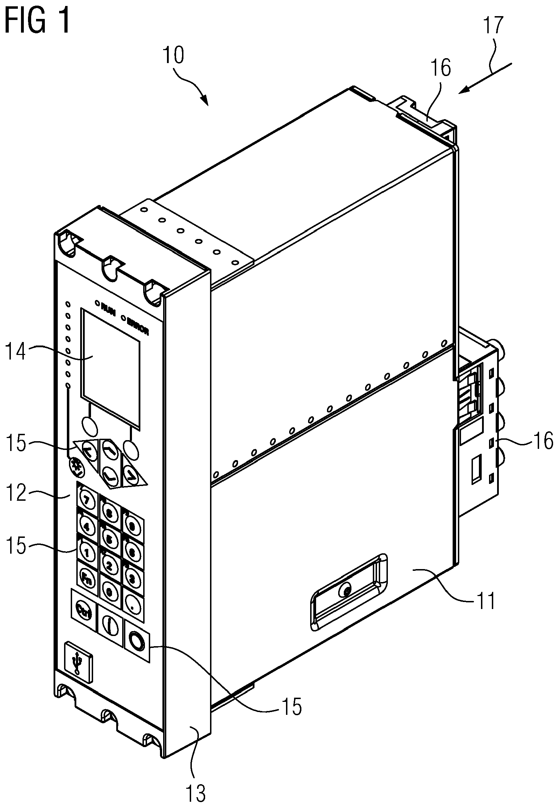

Figur 1 zeigt ein Ausführungsbeispiel eines elektrischen Gerätes 10. Bei dem elektrischen Gerät 10 kann es sich beispielsweise um ein elektrisches Automatisierungsgerät handeln. Konkret kann das elektrische Gerät beispielsweise ein Feld- bzw. Automatisierungsgerät zum Schützen, Steuern und/oder Überwachen einer Energieversorgungsanlage sein.

Das elektrische Gerät 10 weist ein Gehäuse 11 und eine Frontplatte 12 auf, die von der Vorderseite auf das Gehäuse aufgesetzt 11 ist. Die Frontplatte 12 weist einen Rahmen 13 mit einem Überstand auf, der die das Gehäuse an seiner Vorderseite umgreift, so dass ein feuchtigkeitsdichter Übergang zwischen Frontplatte und Gehäuse entsteht. Außerdem umfasst die Frontplatte 12 ein Display 14 sowie Eingabemittel 15 in Form einer Folientastatur, um vor Ort eine Gerätebedienung zu ermöglichen. Auf der Rückseite des Gehäuses sind externe Geräteanschlüsse, z.B. Geräteklemmen, vorgesehen, über die externe elektrische Anschlussleitungen mit dem Gerät 10 verbunden werden können.

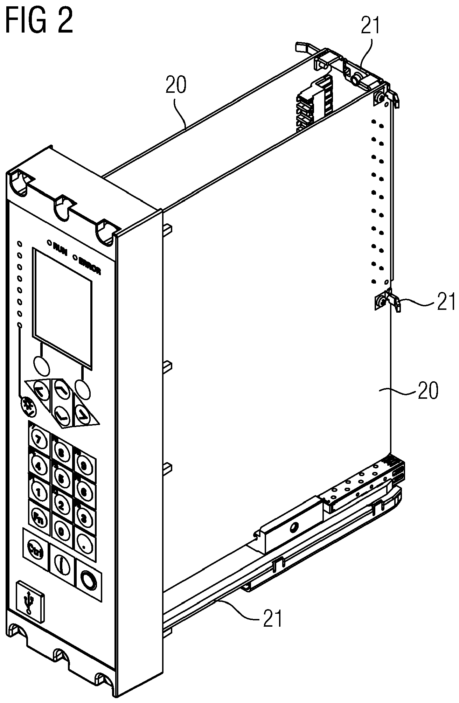

Nachfolgend wird anhand der Figuren 2 bis 9 die Vorgehensweise zur Fertigung des elektrischen Gerätes 10 erläutert. Bei der Konstruktion des Gerätes wurde darauf geachtet, dass die Fertigung möglichst automatisiert und damit kostengünstig durchgeführt werden kann. Dabei soll eine Herstellung unter Verwendung eines Fertigungsroboters möglich sein. Hierfür ist vorgesehen, dass das Gerät 10 aus einer einzigen Fügerichtung gefertigt werden kann. Diese Fügerichtung ist in Figur 1 durch einen Pfeil 17 angegeben. Darüber hinaus wurde auf Schraubverbindungen soweit möglich verzichtet.

Figur 2 zeigt das elektrische Gerät 10 ohne Gehäuse. Man erkennt, dass in dem Gehäuse Leiterplatten 20, 21 angeordnet sind, wobei die Leiterplatten 20 parallel zueinander und die Leiterplatte 21 orthogonal dazu angeordnet ist. Abstandhalter dienen zur Sicherung eines gleichbleibenden Abstands zwischen den Leiterplatten 20 und weisen außerdem federnde Enden auf, mit denen sie an der Gehäuseinnenseite anliegen und über das Gehäuse eine elektrische Erdung der Leiterplatten herstellen.

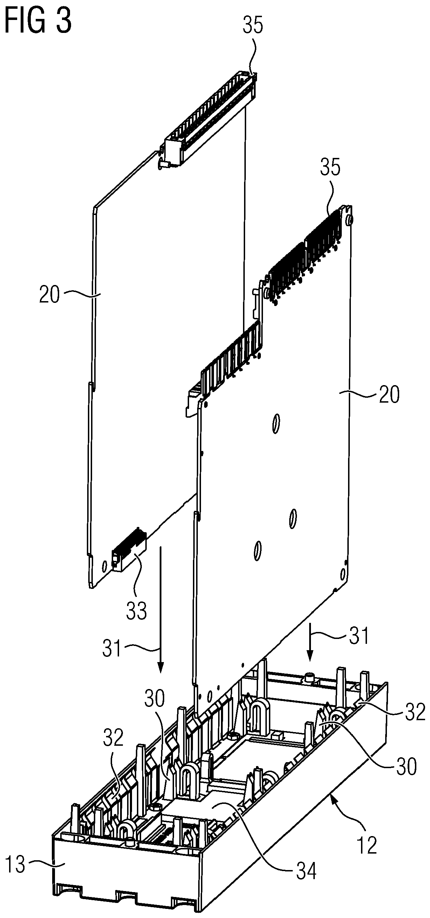

Figur 3 zeigt einen ersten Schritt bei der Fertigung des elektrischen Geräts 10. Hierzu dient die Frontplatte 12 als Basisplatte. Die Leiterplatten 20 werden während dieses Fertigungsschrittes in Haltevorrichtungen 30 eingeschoben. Die Fügerichtung ist durch Pfeile 31 angedeutet. Die Haltevorrichtungen können bevorzugt federnde Klemmelemente aufweisen, mit denen sie die Leiterplatten beidseitig umgreifen und einklemmen. Die Haltevorrichtungen 30 sind bevorzugt aus einem nicht leitenden Kunststoff hergestellt.

In Figur 3 erkennt man, dass der Überstand des Rahmens innen mit Blechfedern 32 versehen ist, die einerseits eine mechanische Befestigung zwischen der Frontplatte 12 und dem Gehäuse 11 und andererseits eine elektrische Erdung zwischen der Frontplatte 12 und dem Gehäuse 11 bewirken. Zumindest eine der Leiterplatten 20 weist einen Steckverbinder 33 auf, über den eine elektrische Verbindung zwischen der fraglichen Leiterplatte 20 und einer auf der gehäuseseitigen Fläche der Frontplatte 12 angeordneten Platine 34 hergestellt werden kann, um das Display und die Eingabemittel mit den Leiterplatten elektrisch zu verbinden.

Außerdem weisen die Leiterplatten 20 auf ihrer der Frontplatte 12 abgewandten Seite weitere Steckverbinder 35 auf, mit denen bei aufgestülptem Gehäuse 11 eine elektrische Verbindung zu den äußeren Geräteanschlüssen 16 hergestellt werden kann.

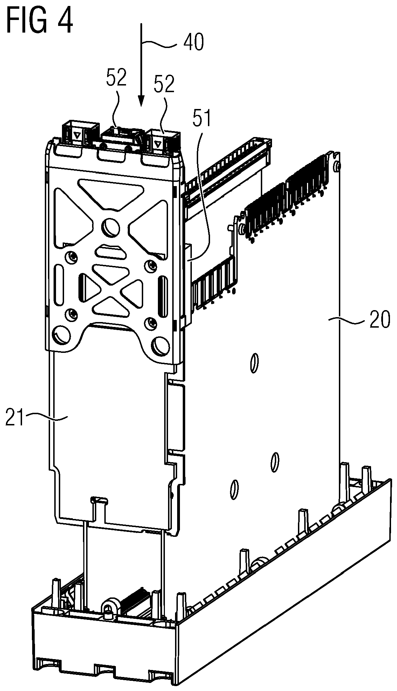

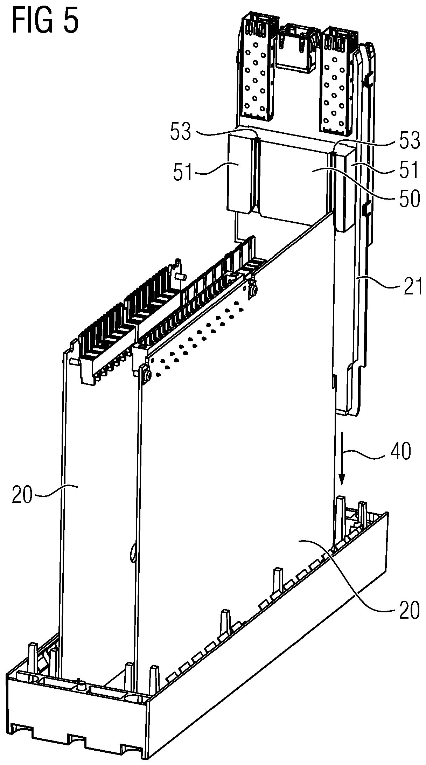

Figuren 4 und 5 zeigen Ansichten eines folgenden Fertigungsschrittes des elektrischen Gerätes 10. Nachdem die parallelen Leiterplatten 20 in die Haltevorrichtungen der Frontplatte eingeschoben worden sind, wird in orthogonaler Ausrichtung zu den Leiterplatten 20 eine weitere Leiterplatte 21 eingeschoben. Die Fügerichtung ist durch Pfeile 40 angegeben.

Auf einer wärmeabgebenden Komponenten, z.B. einer CPU, der weiteren Leiterplatte 21 ist ein Kühlkörper 50 angeordnet. Dieser ist hinsichtlich seiner Konstruktion möglichst einfach gehalten und beispielsweise in Form eines Quaders ausgebildet, dessen Material (z.B. Aluminium) und Volumen derart ausgewählt sind, dass er die seitens der wärmeabgebenden Komponente abgegebene Verlustleistung vollständig aufnehmen kann, ohne eine maximale Temperatur zu überschreiten. Aufgrund seiner konstruktiv einfachen Ausgestaltung findet eine Wärmeabgabe nach außen nicht über eine strukturierte Oberfläche oder Kühlrippen wie bei üblichen Kühlkörpern statt. Vielmehr wird die Wärme durch Konvektion über die Oberfläche an die Luft im Gehäuse und insbesondere durch Wärmeleitung über die außenseitigen Oberflächen 51 des Kühlkörpers 50 an die Innenseite des Gehäuses 11 abgeführt. Dazu ist der Kühlkörper derart bemessen, dass eine Berührung mit einem gewünschten Anpressdruck zwischen seinen Außenseiten und der Innenseite des Gehäuses 11 erfolgt. Dies kann durch eine etwas breitere Bemessung des Kühlkörpers erfolgen. Alternativ kann der Kühlkörper auch schmaler bemessen sein und die Pressung wird beispielsweise durch eine (in der Figur nicht dargestellte) Verschraubung durchgeführt, wobei die Schraube von der Außenseite des Gehäuses in den Kühlkörper geführt ist.

Auf ihrer der Gehäuserückseite zugewandten Seite weist die Leiterplatte 21 Kommunikationsanschlüsse 52 auf, mit denen zwischen einer Kommunikationseinrichtung des Geräts 10, die beispielsweise auf der Leiterplatte 21 ausgebildet sein kann, und weiteren Geräten Daten ausgetauscht werden können. Beispielsweise kann es sich bei den Kommunikationsanschlüssen um eine ethernetkompatible RJ45 Schnittstelle und/oder um USB-Anschlüsse handeln.

In Figur 5 ist zu erkennen, dass der Kühlkörper 50 Führungsnuten 53 aufweist, die beim Einschieben der weiteren Leiterplatte 21 die bereits eingeschobenen Leiterplatten 20 umgreifen und einerseits eine Führung der weiteren Leiterplatte bei der Montage erleichtern, die aus den Leiterplatten 20 und 21 bestehende Anordnung stabilisieren und außerdem während des Betriebs des elektrischen Geräts 10 ein Verwackeln der Leiterplatten 20, 21 verhindern. Zum leichteren Einschieben der weiteren Leiterplatte können die Führungsnuten abgeschrägte Innenseiten aufweisen, um eine selbsttätige Justierung der Leiterplatten 20 bei der Fertigung zu bewirken.

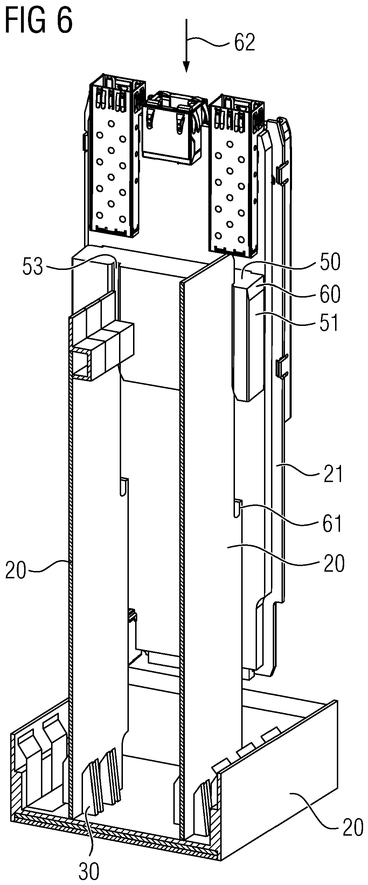

Figur 6 zeigt eine Schnittansicht des elektrischen Gerätes 10 mit in die Frontplatte 12 eingeschobenen Leiterplatten 20 sowie der weiteren Leiterplatte 21 während des Einschiebevorgangs. Die Fügerichtung ist mit dem Pfeil 62 angegeben. Man erkennt, wie die Leiterplatten 20 in den Führungsnuten gehalten und gegen ein Verwackeln gesichert werden.

Außerdem ist in Figur 6 erkennbar, wie die Leiterplatten 20 in der Haltevorrichtung 30 der Frontplatte 12 eingeklemmt sind. Darüber hinaus ist gut erkennbar, dass der Kühlkörper 50 an seinen Außenseiten abgeschrägte Flanken 60 aufweist, um ein Aufstülpen des Gehäuses 11 in einem abschließenden Fertigungsschritt zu vereinfachen.

Schließlich zeigt Figur 6 Halteelemente 61 in Form von Haken bzw. Stiften, die an den Leiterplatten 20 ausgeformt sind und mit Halteeinrichtungen des Kühlkörpers zusammenwirken.

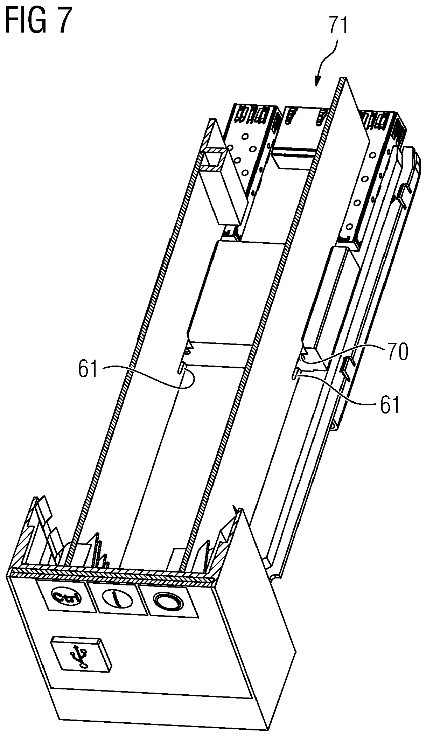

Dies ist in Figur 7 näher dargestellt. Figur 7 zeigt eine Halteeinrichtung 70 in Form von Bohrungen im Bereich der Führungsnuten 53, in die die Halteelemente 61 der Leiterplatten im vollständig eingeschobenen Zustand eingreifen und ein Herausheben der Leiterplatten 20 aus den Führungsnuten verhindern. Hierdurch wird quasi eine Arretierung geschaffen, mit der die Leiterplatten 20 und 21 im montierten zustand zusammengehalten werden. Die Fügerichtung ist durch den Pfeil 71 angegeben.

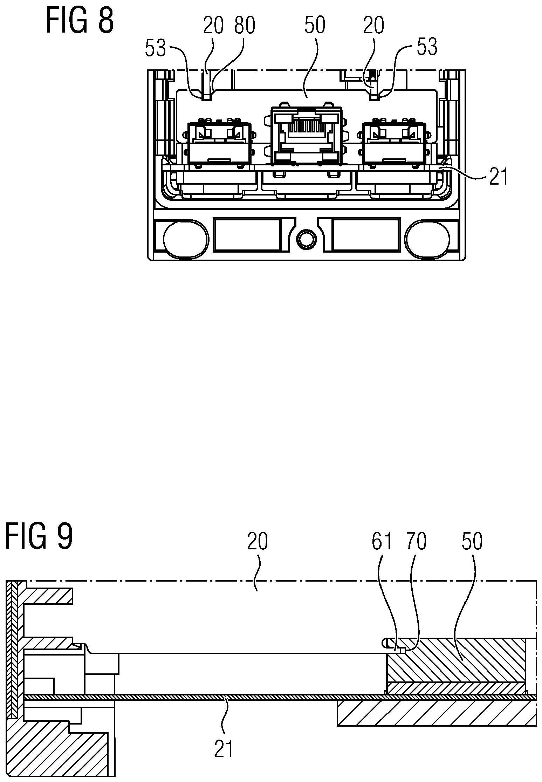

Figur 8 zeigt in einer Schnittdarstellung den unteren Teil des elektrischen Geräts 10 von dessen Rückseite mit montierten Leiterplatten 20 und 21. Deutlich erkennt man, wie die Leiterplatten 20 in den Führungsnuten 53 des Kühlkörpers gehalten und gegen ein seitliches Verwackeln geschützt sind.

Figur 9 zeigt schließlich in einer Schnittdarstellung den unteren Teil des elektrischen Geräts 10 von der Seite. Deutlich erkennt man, wie das an der Leiterplatte 20 ausgeformte Halteelement 61 in die Halteeinrichtung 70 eingreift und die Leiterplatte 20 somit gegen ein Herausheben aus der Führungsnut sichert.

In Bezug auf den Kühlkörper 50 lässt sich somit eine signifikante Funktionsintegration erkennen. Einerseits ist er für den Abtransport der Verlustleistung der wärmeabgegeben Komponente verantwortlich. Andererseits sorgt er auch für eine mechanische Stabilisierung der Leiterplatten untereinander durch Führungsnuten im Kühlkörper sowohl beim Montageprozess als auch für im Dauereinsatz. Hierdurch können sich alle Leiterplatten 20, 21 gegenseitig stabilisieren.

Durch die stringente Einhaltung einer einzigen Fügerichtung sowie einer schraubenlosen Montage kann die Fertigung automatisiert und besonders kostengünstig durchgeführt werden. Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang wie durch die nachfolgenden Patentansprüche definiert zu verlassen.

## Patentansprüche

1. Elektrisches Gerät (10) mit
- einem an der Frontseite offenen Gehäuse (11);
- einer Frontplatte (12), die auf der Frontseite des Gehäuses (11) aufgesetzt ist; und
- Leiterplatten (20, 21), die von dem Gehäuse (11) umfasst sind; wobei
- die Leiterplatten (20, 21) in Haltevorrichtungen (30) eingeschoben sind, die an der dem Gehäuse (11) zugewandten Seite der Frontplatte (12) angeordnet sind; und
- zumindest zwei der Leiterplatten (20, 21) nicht parallel zueinander ausgerichtet sind;
**dadurch gekennzeichnet, dass**
- eine Stirnseite mindestens einer der zumindest zwei Leiterplatten (20) in einer Führungsnut (53) eines Kühlkörpers (50) gehalten ist, der auf der anderen der zumindest zwei Leiterplatten (21) montiert ist.

2. Elektrisches Gerät (10) nach Anspruch 1,
**dadurch gekennzeichnet, dass**
- die zumindest zwei Leiterplatten (20, 21) orthogonal zueinander ausgerichtet sind.

3. Elektrisches Gerät (10) nach Anspruch 1 oder 2,
**dadurch gekennzeichnet, dass**
- das Volumen des Kühlkörpers (50) derart bemessen ist, dass er die von einem wärmeabgebenden Bauteil abgegebene Wärmemenge vollständig aufnehmen kann, wobei eine maximale Grenztemperatur nicht überschritten wird.

4. Elektrisches Gerät (10) nach einem der vorangehenden Ansprüche,
**dadurch gekennzeichnet, dass**
- der Kühlkörper (50) derart bemessen ist, dass seine Oberfläche (51) im eingeschobenen Zustand der Leiterplatte (21) zumindest teilweise an der Innenfläche des Gehäuses (11) anliegt.

5. Elektrisches Gerät nach einem der vorangehenden Ansprüche, **dadurch gekennzeichnet, dass**
- der Kühlkörper (50) im eingeschobenen Zustand der Leiterplatte (21) durch Befestigungsmittel mit dem Gehäuse verbunden ist.

6. Elektrisches Gerät (10) nach einem der vorangehenden Ansprüche,
**dadurch gekennzeichnet, dass**
- der Kühlkörper (50) mindestens zwei parallel verlaufende Führungsnuten (53) aufweist.

7. Elektrisches Gerät (10) nach Anspruch 6,
**dadurch gekennzeichnet, dass**
- in jeder Führungsnut (53) des Kühlkörpers (50) eine Leiterplatte (20) gehalten ist.

8. Elektrisches Gerät (10) nach einem der vorangehenden Ansprüche,
**dadurch gekennzeichnet, dass**
- der Kühlkörper (50) mindestens eine Halteeinrichtung (70) aufweist, in die ein Halteelement (61) einer von einer Führungsnut gehaltenen Leiterplatte (20) eingreift.

9. Elektrisches Gerät (10) nach Anspruch 8,
**dadurch gekennzeichnet, dass**
- die Halteeinrichtung (61) als Bohrung ausgebildet ist, die derart im Bereich einer Führungsnut (53) angeordnet ist, dass eine Leiterplatte (20) beim Einschieben in die Führungsnut (53) mit dem Halteelement (61) in die Bohrung eingreift.

10. Elektrisches Gerät (10) nach einem der vorangehenden Ansprüche,
**dadurch gekennzeichnet, dass**
- die Frontplatte (12) einen Rahmen (13) mit einem das Gehäuse (11) frontseitig umgreifenden Überstand aufweist.

11. Elektrisches Gerät (10) nach einem der vorangehenden Ansprüche,
**dadurch gekennzeichnet, dass**
- auf der Frontseite der Frontplatte (12) Eingabemittel (15) und/oder ein Display (14) angeordnet sind; und
- zum elektrischen Anschluss der Eingabemittel (15) und/oder des Displays (16) mindestens eine der Leiterplatten (20, 21) über einen Steckverbinder (33) mit einer auf der Frontplatte (12) gehäuseseitig angeordneten Platine (34) in Verbindung steht.

12. Elektrisches Gerät (10) nach einem der vorangehenden Ansprüche,
**dadurch gekennzeichnet, dass**
- mindestens eine der Leiterplatten (20, 21) auf ihrer der Gehäuserückseite zugewandten Stirnseite einen weiteren elektrischen Steckverbinder (35) aufweist, der mit einem externen Geräteanschluss (16), über den von außen mit dem Gerät (10) elektrische Anschlüsse hergestellt werden können, zusammenwirkt.

13. Elektrisches Gerät (10) nach einem der vorangehenden Ansprüche,
**dadurch gekennzeichnet, dass**
- die Haltevorrichtungen (30) an der Frontplatte (12) federnde Elemente umfasst, die zum beidseitigen Festklemmen der jeweiligen eingeschobenen Leiterplatte (20) ausgebildet sind.

## Claims

1. Electric device (10) comprising
- a housing (11) that is open on the front side;
- a front panel (12) which is placed on the front side of the housing (11); and
- printed circuit boards (20, 21) which are enclosed by the housing (11); wherein
- the printed circuit boards (20, 21) are inserted into holding devices (30), which are arranged on the side of the front panel (12) that faces the housing (11); and
- at least two of the printed circuit boards (20, 21) are not aligned parallel to one another;
**characterized in that**
- a front face of at least one of the at least two printed circuit boards (20) is held in a guide groove (53) of a heat sink (50), which is mounted on the other of the at least two printed circuit boards (21).

2. Electric device (10) according to Claim 1,
**characterized in that**
- the at least two printed circuit boards (20, 21) are aligned orthogonally to one another.

3. Electric device (10) according to Claim 1 or 2,
**characterized in that**
- the volume of the heat sink (50) is dimensioned in such a way that it is able to completely absorb the amount of heat given off by a heat-emitting component, a maximum limiting temperature not being exceeded.

4. Electric device (10) according to one of the preceding claims,
**characterized in that**
- the heat sink (50) is dimensioned in such a way that its surface (51) rests at least partially on the inner surface of the housing (11) when the printed circuit board (21) is inserted.

5. Electric device according to one of the preceding claims,
**characterized in that**
- when the printed circuit board (21) is inserted, the heat sink (50) is connected to the housing by fastening means.

6. Electric device (10) according to one of the preceding claims,
**characterized in that**
- the heat sink (50) has at least two guide grooves (53) extending in parallel.

7. Electric device (10) according to Claim 6,
**characterized in that**
- a printed circuit board (20) is held in each guide groove (53) of the heat sink (50).

8. Electric device (10) according to one of the preceding claims,
**characterized in that**
- the heat sink (50) has at least one holding device (70), in which a holding element (61) of a printed circuit board (20) held by a guide groove engages.

9. Electric device (10) according to Claim 8,
**characterized in that**
- the holding device (61) is formed as a hole, which is arranged in the region of a guide groove (53) in such a way that a printed circuit board (20) engages with the holding element (61) in the hole when it is inserted into the guide groove (53).

10. Electric device (10) according to one of the preceding claims,
**characterized in that**
- the front panel (12) has a frame (13) with an overhang that encompasses the front side of the housing (11).

11. Electric device (10) according to one of the preceding claims,
**characterized in that**
- input means (15) and/or a display (14) are arranged on the front side of the front panel (12); and
- for the electrical connection of the input means (15) and/or the display (16), at least one of the printed circuit boards (20, 21) is connected via a plug connector (33) to a circuit board (34) arranged on the housing side on the front panel (12).

12. Electric device (10) according to one of the preceding claims,
**characterized in that**
- on its front face facing the rear side of the housing, at least one of the printed circuit boards (20, 21) has a further electric plug connector (35), which interacts with an external device connection (16), via which electrical connections to the device (10) can be made from outside.

13. Electric device (10) according to one of the preceding claims,
**characterized in that**
- the holding devices (30) on the front panel (12) comprises resilient elements, which are designed to clamp the respective inserted printed circuit board (20) firmly on both sides.

## Revendications

1. Appareil (10) électrique comprenant
- un boîtier (11) ouvert du côté avant ;
- une plaque (12) avant, qui est mise sur le côté avant du boîtier (11) ; et
- des plaquettes (20, 21) à circuit imprimé, qui sont entourées du boîtier (11) ; dans lequel
- les plaquettes (20, 21) à circuit imprimé sont introduites dans des dispositifs (30) de maintien, qui sont montés sur la face, tournée vers le boîtier (11), de la plaque (12) avant ; et
- au moins deux des plaquettes (20, 21) à circuit imprimé ne sont pas dirigées parallèlement l'une à l'autre ;
**caractérisé en ce qu'**
- un côté frontal au moins de l'une des au moins deux plaquettes (20) à circuit imprimé est retenu dans une rainure (53) de guidage d'un puits (50) de chaleur, qui est monté sur l'autre des au moins deux plaquettes (21) à circuit imprimé.

2. Appareil (10) électrique suivant la revendication 1,
**caractérisé en ce que**
- les au moins deux plaquettes (20, 21) à circuit sont dirigées orthogonalement l'une par rapport à l'autre.

3. Appareil (10) électrique suivant la revendication 1 ou 2,
**caractérisé en ce que**
- le volume du puits (50) de chaleur est tel qu'il peut absorber complètement la quantité de chaleur cédée par un composant cédant de la chaleur, une température limite maximum n'étant pas dépassée.

4. Appareil (10) électrique suivant l'une des revendications précédentes,
**caractérisé en ce que**
- le puits (50) de chaleur est tel que sa surface (51) s'applique lorsque la plaquette (21) à circuit imprimé est insérée, au moins en partie, à la surface intérieure du boîtier (11).

5. Appareil électrique suivant l'une des revendications précédentes,
**caractérisé en ce que**
- le puits (50) de chaleur est, lorsque la plaquette (21) à circuit imprimé est insérée, relié au boîtier par un moyen de fixation.

6. Appareil (10) électrique suivant l'une des revendications précédentes,
**caractérisé en ce que**
- le puits (50) de chaleur a au moins deux rainures (53) de guidage s'étendant parallèlement.

7. Appareil (10) électrique suivant la revendication 6,
**caractérisé en ce que**
- une plaquette (20) à circuit imprimé est retenue dans chaque rainure (53) de guidage du puits (50) de chaleur.

8. Appareil (10) électrique suivant l'une des revendications précédentes,
**caractérisé en ce que**
- le puits (50) de chaleur a au moins un dispositif (70) de retenue, dans lequel pénètre un élément (61) de retenue d'une plaquette (20) à circuit imprimé, retenu par une rainure de guidage.

9. Appareil (10) électrique suivant la revendication 8,
**caractérisé en ce que**
- le dispositif (61) de retenue est constitué sous la forme d'un trou, qui est disposé dans la partie d'une rainure (53) de guidage, de manière à ce qu'une plaquette (20) à circuit imprimé pénètre dans le trou par l'élément (61) de retenue, lorsqu'elle est introduite dans la rainure (53) de guidage.

10. Appareil (10) électrique suivant l'une des revendications précédentes,
**caractérisé en ce que**
- la plaque (12) avant a un cadre (13), ayant un dépassement entourant, du côté avant, le boîtier (11)

11. Appareil (10) électrique suivant l'une des revendications précédentes,
**caractérisé en ce que**
- sur la face avant de la plaque (12) avant, sont montés des moyens (15) d'introduction et/ou un affichage (14) ; et
- pour la connexion électrique des moyens (15) d'entrée et/ou d'affichage (16), au moins l'une des plaquettes (20, 21) à circuit imprimé est, par un connecteur (33) à enfichage, en liaison avec une platine (34) montée du côté du boîtier sur la plaque (12) avant.

12. Appareil (10) électrique suivant l'une des revendications précédentes,
**caractérisé en ce que**
- au moins l'une des plaquettes (20, 21) à circuit imprimé a, sur son côté frontal tourné vers le côté arrière du boîtier, un autre connecteur (35) électrique à enfichage, qui coopère avec une borne (16) extérieure d'appareil, par laquelle des connexions électriques avec l'appareil (10) peuvent être produites de l'extérieur.

13. Appareil (10) électrique suivant l'une des revendications précédentes,
**caractérisé en ce que**
- les dispositifs (30) de retenue comprennent, sur la plaque (12) avant, des éléments élastiques, qui sont constitués pour le serrage des deux côtés de la plaquette (20) à circuit imprimé respective insérée.
